# EUROPÄISCHE PATENTSCHRIFT

(11) **EP 4 140 265 B1**
(45) Veröffentlichungstag und Bekanntmachung des Hinweises auf die Patenterteilung: **29.04.2026**
(21) Anmeldenummer: 21716594.3
(22) Anmeldetag: 30.03.2021
(51) Int. Cl.: H05K 7/20, G06F 1/20

(54) **KÜHLSYSTEM ZUR FLÜSSIGKEITSIMMERSIONSKÜHLUNG VON ELEKTRONISCHEN BAUTEILEN**
COOLING SYSTEM FOR THE LIQUID IMMERSION COOLING OF ELECTRONIC COMPONENTS
SYSTÈME DE REFROIDISSEMENT POUR LE REFROIDISSEMENT EN IMMERSION LIQUIDE DE COMPOSANTS ÉLECTRONIQUES

(30) Priorität: 25.04.2020 DE 102020002530
(43) Veröffentlichungstag der Anmeldung: 01.03.2023
(73) Patentinhaber: Wieland-Werke AG, 89079 Ulm (DE)
(72) Erfinder: GOTTERBARM, Achim, 89160 Dornstadt (DE); KNAB, Manfred, 89160 Dornstadt (DE); DIETL, Jochen, 89077 Ulm (DE); GAIBLER, Harald, 89616 Rottenacker (DE)
(86) Internationale Anmeldenummer: PCT/EP2021/000031
(87) Internationale Veröffentlichungsnummer: WO 2021/213697

(56) Entgegenhaltungen:
- US-A1- 2017 280 587
- US-A1- 2020 093 038

## Beschreibung

Die Erfindung betrifft ein Kühlsystem zur Flüssigkeitsimmersionskühlung von elektronischen Bauteilen gemäß dem Oberbegriff des Anspruchs 1.

Kühlsysteme zur Flüssigkeitsimmersionskühlung sind beispielsweise als Zweiphasen-Tauchkühlsysteme eine aktive Kühllösung für Elektronikbauteile, die im Betrieb viel Wärme erzeugen. Beim Eintauchen der Bauteile in ein Wärmeübertragungsfluid, das meist einen relativ niedrigen Siedepunkt hat, kann die vom elektronischen Bauteil erzeugte Wärme das umgebende flüssige Wärmeübertragungsfluid verdampfen, wodurch Wärme von dem elektronischen Bauteil abgeführt wird. Eine Kondensatoreinrichtung verflüssigt das dampfförmige Wärmeübertragungsfluid, welches dann in das Reservoir zur Kühlung zurückgeführt wird.

Aus der Druckschrift US 10 512 192 B2 ist ein zweiphasiges Tauchkühlsystem, mit einem Kühlbecken bekannt. Eine Kondensationskammer, in der das beim Kühlvorgang entstehende gasförmige Fluid kondensiert wird, steht in Verbindung mit dem flüssigen Fluid im Kühlbecken. Eine Dampfumleitungsstruktur ist hierbei über den wärmeerzeugenden Elektronikkomponenten angeordnet, die sich innerhalb des Kühlmediums im Kühlbecken befinden. Das verdampfte Fluid wird mittels der Dampfumleitungsstruktur in die Kondensationskammer zur Verflüssigung geleitet.

Wenn jedoch das Tauchkühlsystem geöffnet wird, um den Zugang zu den elektronischen Komponenten oder für andere Systemwartungen zu ermöglichen, tritt ein gewisser Verlust an Wärmeübertragungsfluid auf, indem dampfförmiges Fluid in die Umgebung austritt. Eine Verringerung der Menge an verlorenem Wärmeübertragungsfluid ist umweltschonend und kann erhebliche Kosteneinsparungen beim Betrieb eines Zweiphasen-Tauchkühlsystems bewirken.

In diesem Zusammenhang ist aus der Druckschrift US 10 477 726 B1 ein Kühlsystem für Computerkomponenten bekannt. Im Innenraum eines druckgesteuerten Behälters wird der Innendruck auf bis zu 650 hPa reduziert. Im Behälter befindet sich ein wärmeleitendes, dielektrisches Wärmeübertragungsfluid in flüssiger und gasförmiger Phase, welches bei Atmosphärendruck einen Siedepunkt unter 80 °C aufweist. Im Behälter sind Computerkomponenten angeordnet, die zumindest teilweise in die flüssige Phase des Fluids eingetaucht sind. Mittels eines Kondensators wird das durch die Wärmeentwicklung der Computerkomponenten verdampfte dielektrische Gasphasenfluid zu dielektrischem Flüssigphasenfluid kondensiert. Zum Austauschen von Computerkomponenten im Betriebszustand dient eine Luftschleuse am druckgesteuerten Behälter, über die mittels einer Robotereinrichtung auszutauschende Komponenten ausgewechselt werde können.

Zum Austausch einer Komponente dienen Roboterarme im druckgesteuerten Behälter und außerhalb. Wenn eine Elektronikkomponente nicht richtig funktioniert, wird hierzu eine Entfernungssequenz eingeleitet. Hierbei entfernt der interne Arm die entsprechende Computerkomponente und legt sie durch die innere Luftschleusentür im Inneren der Luftschleuse ab. Sobald diese Sequenz abgeschlossen ist, schließt sich die innere Luftschleusentür, der Luftschleusendruck wird mit dem der Außenatmosphäre ausgeglichen und eine äußere Luftschleusentür geöffnet. Sobald die Außentür geöffnet wurde, entfernt ein externes Roboterarmsystem die Komponente aus der Luftschleuse.

Das Innere der Luftschleuse kann mit Stickstoff und/oder einem anderen inerten Gas gespült werden, bevor die Luftschleuse zur Außenumgebung geöffnet wird. Dies hat den Effekt, dass der Verlust an dielektrischem Fluiddampf geringer gehalten wird und insbesondere auch keine Luft aus der Umgebung ins Innere des Gefäßes tritt. Dennoch findet ein Gasaustausch des verwendeten Inertgases aus der Luftschleuse ins Innere des Kühlsystems statt.

Die Druckschriften US 2020093038 A1 und US 2017280587 A1 offenbaren ebenfalls Tauchkühlsysteme.

Der Erfindung liegt die Aufgabe zugrunde, ein Kühlsystem zur Flüssigkeitsimmersionskühlung von elektronischen Bauteilen bezüglich der Verringerung des Verlusts an Wärmeübertragungsfluid weiterzubilden.

Die Erfindung wird durch die Merkmale des Anspruchs 1 wiedergegeben. Die weiteren rückbezogenen Ansprüche betreffen vorteilhafte Aus- und Weiterbildungen der Erfindung.

Die Erfindung schließt ein Kühlsystem zur Flüssigkeitsimmersionskühlung von elektronischen Bauteilen ein. Das Kühlsystem umfasst einen Behälter, der im Inneren flüssiges Wärmeübertragungsfluid enthält, in das elektronische Bauteile eingetaucht werden können, wobei der Behälter einen Gasraum über der Oberfläche des flüssigen Wärmeübertragungsfluids aufweist. Zudem umfasst das Kühlsystem eine Wärmeaustauschereinrichtung im Gasraum des Behälters zur Bildung von flüssigem Wärmeübertragungsfluid. Das Kühlsystem weist am Behälter eine Schleuseneinrichtung zum Austausch elektronischer Bauteile auf. Die Schleuseneinrichtung weist einen Schleusenraum auf, der zum Gasraum des Behälters gegenüber einem Gasaustausch hermetisch abgedichtet ist.

Zudem kann das Kühlsystem vorteilhafterweise eine Steuereinrichtung aufweisen, die dafür ausgelegt ist, um den Betrieb der Fluidzirkulation beispielsweise als Funktion der Temperatur des Wärmeübertragungsfluids und die Druckverhältnisse im Behälter und/oder in der Schleuseneinrichtung zu regeln.

Die Erfindung geht dabei von der Überlegung aus, dass durch die hermetische Abdichtung keine Luft, Wasserdampf oder auch Inertgas in den Behälter mit den gekühlten Elektronikkomponenten gelangt. So wird im Kühlprozess das gasförmige Wärmeübertragungsfluid nicht durch Fremdgase kontaminiert. Dies geschieht durch eine Barriere, welche den Schleusenraum vom Behälter trennt und einen Stoffaustausch mit dem gasförmigen Wärmeübertragungsfluid verhindert. Die Schleuseneinrichtung ist gegenüber einem Materieaustausch mit dem Behälter absolut dicht. Dies wird insbesondere dadurch erreicht, dass flüssiges Wärmeübertragungsfluid dazu verwendet wird, die Schleuse gegenüber einem Gasdurchtritt abzudichten. Der Übergangsbereich vom Behälter zum Schleusenraum ist dabei mit flüssigem Wärmeübertragungsfluid gefüllt.

Im Behälter sind die Elektronikbauteile in für eine Kühlung geeigneter Weise in einem Bad von Wärmeübertragungsfluid angeordnet, welche durch Verdampfung dieses flüssigen Fluids gekühlt werden. Hierbei können vor und/oder während der Inbetriebnahme der Anteil der nicht kondensierbaren Gase aus dem System entfernt werden. Die Wärmeaustauschereinrichtung des Kühlsystems kann zur Bildung von flüssigem Wärmeübertragungsfluid im Gasraum des Behälters als Bündel von Wärmeaustauscherrohren ausgeführt sein. Hierbei können auch mehrere Rohrbündel im Gasraum des Behälters verteilt angeordnet sein.

Die Schleuseneinrichtung ist geeignet, dass die Teile über die gegenüber einem Gasaustausch hermetisch abdichtende Schleuse nahezu ohne Druckdifferenz zwischen Umgebung und Behälter zugeführt werden können, und somit das Eindringen von Luft und anderen Medien in das System sowie der Verlust des Wärmeübertragungsfluids aus dem System verhindert oder zumindest wesentlich reduziert wird. Hierbei kann die Schleuseneinrichtung auch vom Behälter abtrennbar ausgeführt sein. Beispielsweise kann die Schleuse als Modul ausgeführt sein, welches in den Behälter einbringbar und wieder entfernbar ist und welches in das flüssige Wärmeübertragungsfluid mit einer gewissen Eintauchtiefe eintaucht. Geeignet ist beispielsweise ein quadratisches oder rechteckiges Vierkantmodul, welches im einsatzbereiten Zustand im Behälter mit der unteren Öffnung in das flüssige Wärmeübertragungsfluid eintaucht und dessen obere Öffnung mit einem Deckel gegenüber der Außenumgebung verschließbar ist.

Der Schleusenraum der Schleuseneinrichtung kann auch mit dem Wärmeträgerfluid aus dem Behälter oder einem separaten Vorratsbehälter geflutet werden. Dies gelingt beispielsweise dadurch, dass der Gasdruck im Behälter auf ein Maß entsprechend erhöht wird, so dass flüssiges Wärmeübertragungsfluid nach dem Prinzip kommunizierender Röhren den Druckverhältnissen entsprechend in den Schleusenraum eintritt und das dort vorhandene Gas verdrängt. Aufgrund geeigneter Druckverhältnisse von Außendruck und Innendruck kann der Schleusenraum zum Austausch der Elektronikbauteile auch vollständig mit flüssigem Wärmeübertragungsfluid geflutet sein. Nach dem Verschließen der Schleuseneinrichtung gegenüber der Außenumgebung sind im Schleusenraum dann keine Außenluft oder anderweitige Fremdgase vorhanden.

Im Behälter sind die Elektronikbauteile in für den Kühlvorbedarf geeigneter Art und Weise im Bad von Wärmeübertragungsfluid angeordnet und werden durch Verdampfung dieser Flüssigkeit gekühlt. Mittels Sensoren wird von einer Steuereinrichtung eine Überwachung und Steuerung von Druck, Temperatur, Leitfähigkeit sowie alle verfahrensrelevanten Parameter vorgenommen.

Der besondere Vorteil besteht darin, dass durch die Schleuseneinrichtung die Kühlsysteme hinsichtlich Effizienz, Verlust von Wärmeübertragungsfluid und Feuchtigkeitseintrag in das System optimiert ausgeführt sind.

In bevorzugter Ausgestaltung der Erfindung kann zur hermetischen Abdichtung des Schleusenraums eine Trennwand angeordnet sein, welche mit einer Eintauchtiefe in das flüssige Wärmeübertragungsfluid eintaucht. Hierdurch entsteht ein aus dem flüssigen Wärmeübertragungsfluid gebildeter Siphon, der den Gasraum im Behälter und den Gasraum des Schleusenraums gegenüber einem Gasaustausch abdichtet.

Vorteilhafterweise kann die Eintauchtiefe der Trennwand variabel ausgeführt sein. Hierdurch kann bei verschlossener Schleuseneinrichtung die Trennwand zur einfachen weiteren Positionierung der elektronischen Bauteile in ihre Betriebsposition zumindest teilweise beseitigt werden. Diese Trennwand kann beispielsweise verschoben oder auch durch einen Klappmechanismus beseitigt werden.

In vorteilhafter Ausgestaltung der Erfindung kann ein Bestückungssystem im Behälter angeordnet sein, mit dem für einen Austausch die elektronischen Bauteile von der Schleuseneinrichtung an die Betriebsposition transportiert werden können. Ein Bestückungssystem kann aus Roboterarmen oder aus Linearantriebsvorrichtungen bestehen. Bei einer geeigneten Ausbildung der Vorrichtung lässt sich ein Austausch der Bauteile über ein vollautomatisches Bestückungssystem durchführen. Alternativ können für einen Austausch der elektronischen Bauteile von der Schleuseneinrichtung an die Betriebsposition auch Handschuhe an geeigneten Behälteröffnungen angeordnet sein. So ist eine Bestückung durch den manuellen Zugriff ins Innere des Behälters nach dem Prinzip einer gasdichten Glovebox ermöglicht.

Bei einer vorteilhaften Ausführungsform der Erfindung kann im Schleusenraum ein Speicher zur Zwischenlagerung von elektronischen Bauteilen vorgesehen sein. Mit einem zusätzlichen oder angrenzenden Speicher ausgestattet, ist ein Zugang zu den auszutauschenden Komponenten ohne Öffnen des Kühlsystems einfach möglich.

Vorteilhafterweise kann eine weitere Wärmeaustauschereinrichtung als Schleusenkühlung ausgeführt sein, welche das im Schleusenraum befindliche Wärmeübertragungsfluid gesondert temperieren kann. Das in der Schleuse befindliche Wärmeübertragungsfluid kann damit separat vom gesamten Kreislauf temperiert werden. Dadurch können auch mögliche Reste an gasförmigem Wärmeübertragungsfluid in die flüssige Phase überführt werden. Die Verflüssigung des Dampfes kann durch einen integrierten oder angrenzenden Verflüssiger stattfinden. Zudem ist es vorteilhaft, durch ein kühles Wärmeübertragungsfluid im Schleusenraum, den Gasdruck beim Öffnen der Schleuseneinrichtung nach außen gering zu halten.

Bei einer vorteilhaften Ausführungsform können die Schleuseneinrichtung und/oder der Behälter über eine Entgasungseinrichtung verfügen, mit dem nicht kondensierbare Gase von dem gasförmigen Wärmeübertragungsfluid getrennt werden können. Auf diese Weise kann auch der zu einem geringen Anteil in das Kühlsystem eindringende Gasanteil aus dem Kühlkreislauf entfernt werden.

Vorteilhafterweise kann die Schleuseneinrichtung über einen Gasanschluss mit einem Schutzgas geflutet werden. Insbesondere mit Inertgasen können störende Restgase, wie beispielsweise Umgebungsluft, aus dem Schleusenraum entfernt werden.

Vorteilhafterweise kann zusätzlich ein Druckausgleichsbehälter am Behälter und/oder an der Schleuseneinrichtung angeordnet sein. Mit einem Druckausgleichsbehälter können die Pegelhöhe der flüssigen Fluidphase im Gasraum der Behälters und im Schleusenraum genau reguliert werden. Mit einer derartigen Einrichtung können auch Entgasungsvorgänge im Schleusenraum, beispielsweise nach einem Schleusenvorgang, durchgeführt werden.

Vorteilhafterweise kann der Behälter mit einer Zusatzheizung ausgestattet sein, die als Unterstützung zur Verdampfung des Wärmeübertragungsfluids dient. Diese Einrichtung kann unabhängig vom Betrieb der elektronischen Bauteile bzw. der Kühlleistung der Wärmeaustauschereinrichtung eine Druckregulierung des Kühlsystems vornehmen.

In vorteilhafter Ausgestaltung der Erfindung kann der Behälter als Druckbehälter ausgeführt sein, der mit einem Unterdruck und/oder Überdruck arbeitet. Zum Schleusen von elektronischen Bauteilen kann es zur Niveauregelung des Pegels des flüssigen Fluidniveaus im Schleusenraum nötig sein, die Drucklage gegenüber dem Umgebungsdruck der Luft zu regulieren. So kann das Kühlsystem sowohl unter Überdruck als auch unter Unterdruck variabel gegenüber der Umgebungsatmosphäre eingestellt werden, ohne den Betrieb negativ zu beeinträchtigen oder zu unterbrechen.

Ausführungsbeispiele der Erfindung werden anhand der schematischen Zeichnungen näher erläutert.

Darin zeigen:
- Fig. 1: eine schematische Schrägansicht eines Kühlsystems,
- Fig. 2: eine schematische Frontansicht eines Kühlsystems mit einer vorteilhaften Ausführungsform einer Schleuseneinrichtung, und
- Fig. 3: eine schematische Frontansicht eines Kühlsystems mit einer weiteren Ausführungsform einer Schleuseneinrichtung.

Einander entsprechende Teile sind in allen Figuren mit denselben Bezugszeichen versehen.

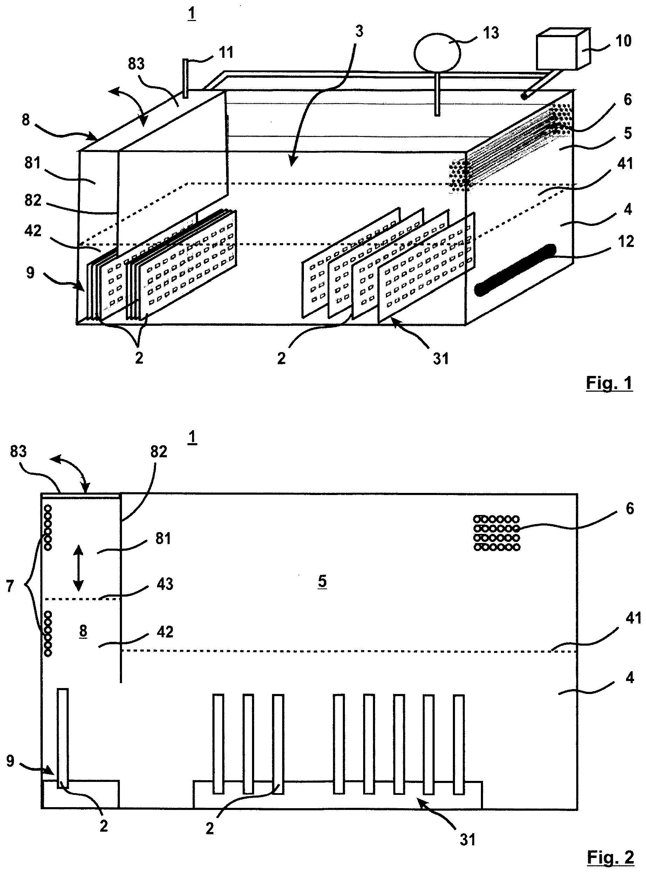

Fig. 1 zeigt eine schematische Schrägansicht eines Kühlsystems 1 zur Flüssigkeitsimmersionskühlung von elektronischen Bauteilen 2. Das Kühlsystem 1 umfasst einen Behälter 3 und eine Schleuseneinrichtung 8 zum Austausch elektronischer Bauteile 2. Das im Inneren des Behälters 3 befindliche flüssige dielektrische Wärmeübertragungsfluid 4 erstreckt sich bis in den Schleusenraum 81 der Schleuseneinrichtung 8. Das im Schleusenraum 81 befindliche flüssige Wärmeübertragungsfluid 42 bildet zusammen mit der Trennwand 82 gegenüber dem Gasraum 5 des Behälters 3 eine hermetische Abdichtung gegenüber einem Gasaustausch. Zur hermetischen Abdichtung taucht die Trennwand 82 in das flüssige Wärmeübertragungsfluid 4 ein und trennt so den Schleusenraum 81 vom Gasraum 5 des Behälters 3 gasseitig ab.

Im Kühlsystem 1 kann ein in Fig. 1 nicht dargestelltes automatisches Bestückungssystem im Behälter 3 angeordnet sein, mit dem für einen Austausch die elektronischen Bauteile 2 von der Schleuseneinrichtung 8 an die Betriebsposition 31 transportiert werden können. Einen Transport der elektronischen Bauteile 2 können Greifarme von Robotern oder lineare Transportsysteme vornehmen, welche automatisiert auszutauschende elektronische Bauteile 2 aus der Betriebsposition 31 abholen und beispielsweise im Speicher 9 der Schleuseneinrichtung 8 ablegen. In umgekehrter Reihenfolge werden einzubauende betriebsbereite elektronische Bauteile 2 vom Speicher 9 mittels dem Bestückungssystem abgeholt und in die Betriebsposition 31 überführt. Auch die Schleuseneinrichtung 8 selbst kann durch automatisierte Vorrichtungen von außen bedient werden.

Für ein Austauschen von elektronischen Bauteilen 2 wird der Deckel 83 der Schleuseneinrichtung 8 geöffnet und ein Bauteil 2 in der Schleuse im Speicher 9 abgelegt. Schadhafte Teile werden von dort über die Schleuse nach Außen gebracht. Vor einem Öffnen des Deckels 83 kann über einen Gasanschluss 11 beispielsweise Inertgas in den Schleusenraum 81 eingeleitet werden, welches dann zumindest teilweise zusammen mit einem im Schleusenraum 81 befindlichen Anteil an gasförmigem Wärmeübertragungsfluid über eine Entgasungseinrichtung 10 abgeleitet wird. Hierdurch entsteht ein Spülvorgang des Schleusenraums 81, so dass beim Öffnen des Deckels 83 kein oder nur ein äußerst geringer Anteil an gasförmigem Wärmeübertragungsfluid aus der Schleuse austritt. Nach dem Schließen des Deckels 83 kann durch einen erneuten Spülvorgang mit Inertgas der Schleusenraum 81 von der Umgebungsluft befreit werden. Sollte gegenüber dem Atmosphärendruck der Umgebung ein Druckausgleich bei Schleusen benötigt werden, so kann ein Druckausgleichsbehälter 13 den benötigten Druck im Gasraum 5 aufbauen. Ebenso kann ein Druckausgleich über eine im flüssigen Wärmeübertragungsfluid 4 im Behälter 3 angeordnete Zusatzheizung 12 während des Schleusenvorgangs vollzogen werden. Die Zusatzheizung 12 erhöht dabei über den Schleusenzeitraum das sonst unter Unterdruck arbeitende Kühlsystem 1 den Innendruck im Gasraum 5 und stellt so den benötigten Druckausgleich her. Die Kühlleistung der Wärmeaustauschereinrichtung 6 ist davon nicht weiter beeinflusst. Dennoch kann auch diese für eine Druckregelung eingesetzt werden.

Fig. 2 zeigt eine schematische Frontansicht eines Kühlsystems 1 mit einer vorteilhaften Ausführungsform einer Schleuseneinrichtung 8. In der Schleuseneinrichtung 8 ist eine Schleusenkühlung 7 angeordnet, welche die Restanteile des gasförmigen Wärmeübertragungsfluids verflüssigt und zudem das flüssige Wärmeübertragungsfluid 4 im Schleusenraum 42 in der Temperatur weiter herabsetzt. Hierdurch sinkt insbesondere in der Schleuseneinrichtung 8 der Partialdruck des Wärmeübertragungsfluids beim Schleusenvorgang von elektronischen Bauteilen 2. Für den Fall, dass im Gasraum 5 ein Überdruck aufgebaut wird, steigt die Fluid-Oberfläche 43 in der Schleuseneinrichtung 8 an. Dadurch reduziert sich das Gasvolumen im Schleusenraum 81. Beim Öffnen des Deckels 83 findet dann ein geringerer oder beim vollständigen Fluten des Schleusenraums 81 kein Gasaustausch mit der Umgebungsluft statt.

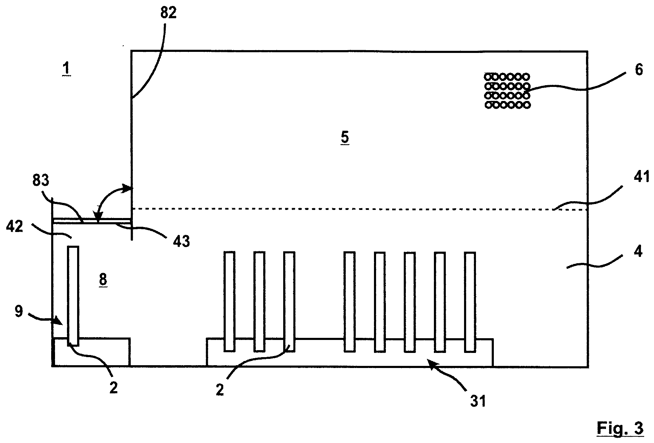

Fig. 3 zeigt eine schematische Frontansicht eines Kühlsystems 1 mit einer weiteren Ausführungsform einer Schleuseneinrichtung 8. Bei dieser Schleuseneinrichtung kann die Fluid-Oberfläche 41 im Gasraum 5 auf einem gegenüber der Fluid-Oberfläche 43 im Schleusenraum 8 auf einem höheren Niveau sein und umgekehrt, je nachdem ob im Gasraum 5 beim Kühlungsprozess ein Unter- oder ein Überdruck vorliegt. Der nach außen abschließende Deckel 83 liegt nun direkt auf dem flüssigen Wärmeübertragungsfluid 42 in der Schleuseneinrichtung 8 auf. Der Deckel 83 dichtet nach einem Schleusenvorgang den Schleusenraum 81 gegenüber der Außenluft vollständig ab. Ein Austausch der elektronischen Bauteile 2 kann nun direkt nach Öffnen des Deckels 83 vorgenommen werden. In diesem Fall kann auch eine einfache Bestückung oder Entleerung des gut zugänglichen Speichers 9 vorgenommen werden. Nach dem Schleusenvorgang wird die Außenluft unmittelbar durch den Deckel 83 verdrängt. Hierzu können im Deckel 83 kleine verschließbare Entlüftungslöcher angeordnet sein.

### Bezugszeichenliste

- 1: Kühlsystem
- 2: elektronisches Bauteil
- 3: Behälter
- 31: Betriebsposition
- 4: flüssiges Wärmeübertragungsfluid
- 41: Fluid-Oberfläche in Gasraum
- 42: flüssiges Wärmeübertragungsfluid in Schleusenraum
- 43: Fluid-Oberfläche in Schleusenraum
- 5: Gasraum
- 6: Wärmeaustauschereinrichtung
- 7: weitere Wärmeaustauschereinrichtung, Schleusenkühlung
- 8: Schleuseneinrichtung
- 81: Schleusenraum
- 82: Trennwand
- 83: Deckel
- 9: Speicher
- 10: Entgasungseinrichtung
- 11: Gasanschluss
- 12: Zusatzheizung
- 13: Druckausgleichsbehälter

## Patentansprüche

1. Kühlsystem (1) zur Flüssigkeitsimmersionskühlung von elektronischen Bauteilen (2), umfassend
- einen Behälter (3), der im Inneren flüssiges Wärmeübertragungsfluid (4) enthält, in das elektronische Bauteile (2) eingetaucht werden können, wobei der Behälter (3) einen Gasraum (5) über der Oberfläche (41) des flüssigen Wärmeübertragungsfluids (4) aufweist,
- eine Wärmeaustauschereinrichtung (6) im Gasraum (5) des Behälters (3) zur Bildung von flüssigem Wärmeübertragungsfluid (4),
- wobei das Kühlsystem (1) am Behälter (3) eine Schleuseneinrichtung (8) zum Austausch elektronischer Bauteile (2) aufweist,
**dadurch gekennzeichnet, dass**
die Schleuseneinrichtung (8) einen Schleusenraum (81) aufweist, der zum Gasraum (5) des Behälters (3) gegenüber einem Gasaustausch hermetisch abgedichtet ist, **dadurch gekennzeichnet, dass** zur hermetischen Abdichtung des Schleusenraums (81) vom Gasraum (5) eine Trennwand (82) angeordnet ist, welche mit einer Eintauchtiefe in das flüssige Wärmeübertragungsfluid (4) eintaucht.

2. Kühlsystem (1) nach Anspruch 1, **dadurch gekennzeichnet, dass** die Eintauchtiefe der Trennwand (82) variabel ausgeführt ist.

3. Kühlsystem (1) nach einem der Ansprüche 1 oder 2, **dadurch gekennzeichnet, dass** ein Bestückungssystem im Behälter (3) angeordnet ist, mit dem für einen Austausch die elektronischen Bauteile (2) von der Schleuseneinrichtung (8) an die Betriebsposition (31) transportiert werden können.

4. Kühlsystem (1) nach einem der Ansprüche 1 bis 3, **dadurch gekennzeichnet, dass** im Schleusenraum (81) ein Speicher (9) zur Zwischenlagerung von elektronischen Bauteilen (2) vorgesehen ist.

5. Kühlsystem (1) nach einem der Ansprüche 1 bis 4, **dadurch gekennzeichnet, dass** eine weitere Wärmeaustauschereinrichtung (7) als Schleusenkühlung ausgeführt ist, welche das im Schleusenraum (81) befindliche Wärmeübertragungsfluid (42) gesondert temperieren kann.

6. Kühlsystem (1) nach einem der Ansprüche 1 bis 5, **dadurch gekennzeichnet, dass** die Schleuseneinrichtung (8) und/oder der Behälter (3) über eine Entgasungseinrichtung (10) verfügt, mit dem nicht kondensierbare Gase von dem gasförmigen Wärmeübertragungsfluid getrennt werden können.

7. Kühlsystem (1) nach einem der Ansprüche 1 bis 6, **dadurch gekennzeichnet, dass** die Schleuseneinrichtung (8) über einen Gasanschluss (11) mit einem Schutzgas geflutet werden kann.

8. Kühlsystem (1) nach einem der Ansprüche 1 bis 7, **dadurch gekennzeichnet, dass** zusätzlich ein Druckausgleichsbehälter (13) am Behälter (3) und/oder an der Schleuseneinrichtung (8) angeordnet ist.

9. Kühlsystem (1) nach einem der Ansprüche 1 bis 8, **dadurch gekennzeichnet, dass** der Behälter (3) mit einer Zusatzheizung (12) ausgestattet ist, die als Unterstützung zur Verdampfung des Wärmeübertragungsfluids (4) dient.

10. Kühlsystem (1) nach einem der Ansprüche 1 bis 9, **dadurch gekennzeichnet, dass** der Behälter (3) als Druckbehälter ausgeführt ist, der mit einem Unterdruck und/oder Überdruck arbeitet.

## Claims

1. Cooling system (1) for liquid immersion cooling of electronic components (2), comprising
- a container (3) which contains therein liquid heat transfer fluid (4) in which electronic components (2) can be immersed, wherein the container (3) has a gas compartment (5) over the surface (41) of the liquid heat transfer fluid (4),
- a heat exchanger device (6) in the gas compartment (5) of the container (3) for forming liquid heat transfer fluid (4),
- wherein the cooling system (1) has on the container (3) a lock device (8) for exchanging electronic components (2),
**characterized in that**
the lock device (8) has an airlock chamber (81) which is hermetically sealed against a gas exchange with respect to the gas compartment (5) of the container (3), **characterised in that** in order to hermetically seal the airlock chamber (81) from the gas compartment (5) there is arranged a partition wall (82) which is introduced with an immersion depth into the liquid heat transfer fluid (4).

2. Cooling system (1) according to claim 1, **characterised in that** the immersion depth of the partition wall (82) is configured to be variable.

3. Cooling system (1) according to either claim 1 or claim 2, **characterised in that** there is arranged in the container (3) a supply system by means of which for an exchange the electronic components can be transported from the lock device (8) to the operating position (31).

4. Cooling system (1) according to any one of claims 1 to 3, **characterised in that** a store (9) for temporary storage of electronic components (2) is provided in the airlock chamber (81).

5. Cooling system (1) according to any one of claims 1 to 4, **characterised in that** another heat exchanger device (7) is in the form of a lock cooling system which can separately control the temperature of the heat transfer fluid (42) located in the airlock chamber (81).

6. Cooling system (1) according to any one of claims 1 to 5, **characterised in that** the lock device (8) and/or the container (3) has/have a degassing device (10) by means of which gases which cannot be condensed can be separated from the gaseous heat transfer fluid.

7. Cooling system (1) according to any one of claims 1 to 6, **characterised in that** the lock device (8) can be flooded with a protective gas via a gas connection (11).

8. Cooling system (1) according to any one of claims 1 to 7, **characterised in that** a pressure compensation container (13) is additionally arranged on the container (3) and/or on the lock device (8).

9. Cooling system (1) according to any one of claims 1 to 8, **characterised in that** the container (3) is provided with a supplementary heating unit (12) which acts as a support for evaporation of the heat transfer fluid (4).

10. Cooling system (1) according to any one of claims 1 to 9, **characterised in that** the container (3) is in the form of a pressure container which functions with a reduced pressure and/or excess pressure.

## Revendications

1. Système de refroidissement (1) pour le refroidissement de composants électroniques (2) par immersion de liquide, comprenant
- un récipient (3) contenant à l'intérieur un fluide liquide caloporteur (4) dans lequel des composants électroniques (2) peuvent être immergés, le récipient (3) comportant un espace de gaz (5) au-dessus de la surface (41) du fluide liquide caloporteur (4),
- un dispositif d'échange de chaleur (6) dans l'espace de gaz (5) du récipient (3) pour former un fluide liquide caloporteur (4),
- le système de refroidissement (1) présentant sur le récipient (3) un dispositif d'écluse (8) pour le remplacement de composants électroniques (2),
**caractérisé en ce que**
le dispositif d'écluse (8) présente une chambre d'écluse (81) qui est rendue hermétiquement étanche par rapport à l'espace de gaz (5) du récipient (3) contre un échange de gaz, **caractérisé en ce que** pour rendre hermétiquement étanche la chambre d'écluse (81) par rapport à l'espace de gaz (5), une paroi de séparation (82) est agencée, laquelle plonge avec une profondeur d'immersion dans le fluide liquide caloporteur (4).

2. Système de refroidissement (1) selon la revendication 1, **caractérisé en ce que** la profondeur d'immersion de la paroi de séparation (82) est réalisée de manière variable.

3. Système de refroidissement (1) selon l'une des revendications 1 ou 2,
**caractérisé en ce**
**qu'**un système d'équipement est agencé dans le récipient (3), avec lequel les composants électroniques (2) peuvent être transportés du dispositif d'écluse (8) à la position de fonctionnement (31) pour un remplacement.

4. Système de refroidissement (1) selon l'une des revendications 1 à 3, **caractérisé en ce qu'**il est prévu dans la chambre d'écluse (81) un réservoir (9) pour le stockage intermédiaire de composants électroniques (2).

5. Système de refroidissement (1) selon l'une des revendications 1 à 4, **caractérisé en ce qu'**un autre dispositif d'échange de chaleur (7) est réalisé sous la forme d'un refroidissement par écluse qui peut tempérer séparément le fluide caloporteur (42) se trouvant dans la chambre d'écluse (81).

6. Système de refroidissement (1) selon l'une des revendications 1 à 5, **caractérisé en ce que** le dispositif d'écluse (8) et/ou le récipient (3) est doté d'un dispositif de dégazage (10) permettant de séparer les gaz non condensables du fluide caloporteur gazeux.

7. Système de refroidissement (1) selon l'une des revendications 1 à 6, **caractérisé en ce que** le dispositif d'écluse (8) peut être inondé d'un gaz de protection par l'intermédiaire d'un raccord de gaz (11).

8. Système de refroidissement (1) selon l'une des revendications 1 à 7, **caractérisé en ce qu'**un réservoir d'équilibrage de pression (13) est en outre agencé sur le récipient (3) et/ou sur le dispositif d'écluse (8).

9. Système de refroidissement (1) selon l'une quelconque des revendications 1 à 8, **caractérisé en ce que** le récipient (3) est équipé d'un chauffage auxiliaire (12) qui sert de support à l'évaporation du fluide caloporteur (4).

10. Système de refroidissement (1) selon l'une des revendications 1 à 9, **caractérisé en ce que** le récipient (3) est réalisé sous forme de réservoir sous pression fonctionnant en dépression et/ou en surpression.
